# EUROPÄISCHE PATENTSCHRIFT

(11) **EP 0 727 853 B1**
(45) Veröffentlichungstag und Bekanntmachung des Hinweises auf die Patenterteilung: **20.09.2000**
(21) Anmeldenummer: 96100121.1
(22) Anmeldetag: 05.01.1996
(51) Int. Cl.: H02B 1/30

(54) **Rahmenkonstruktion für Gestelle und Gehäuse von Baugruppenträgern und Schränken zur Aufnahme von elektrischen und/oder elektronischen Bauteilen**
Frame construction for racks and housings of module carriers for receiving electric and/or electronic components
Structure à cadre pour châssis et boîtiers de supports de modules et armoires pour la réception de composants électriques et/ou électroniques

(30) Priorität: 14.02.1995 DE 29502404 U; 02.05.1995 DE 19515934
(43) Veröffentlichungstag der Anmeldung: 21.08.1996
(73) Patentinhaber: Knürr Mechanik für die Elektronik AG, D-81829 München (DE)
(72) Erfinder: Flamme,Hans, D-82008 Unterhaching (DE); Rheindt,Gerd, D-85540 Haar (DE); Simon, Peter, D-81377 München (DE)
(74) Vertreter: Heim, Hans-Karl, Dipl.-Ing.

(56) Entgegenhaltungen:
- EP-A- 0 399 595
- DE-A- 4 412 462
- DE-U- 9 109 577
- FR-A- 2 420 233
- FR-A- 2 702 314

## Beschreibung

Die Erfindung betrifft ein Konstruktionssystem für Rahmen, Gestelle und Gehäuse, insbesondere für Baugruppenträger und Schränke, beispielsweise für Geräteschränke zur Aufnahme von elektrischen und elektronischen Baugruppen, Geräten und Leiterplatten, gemäß dem Oberbegriff des Anspruchs 1.

Konstruktionen für Rahmen, Gestelle, Gehäuse, Baugruppenträger und Schränke weisen vertikal und horizontal angeordnete Bauteile, in der Regel abgelängte Profilholme, auf, welche in Verbindungsbereichen, insbesondere in Eckbereichen, miteinander verbunden werden. Es sind Schrankkonstruktionen bekannt, bei denen Vertikal-, Horizontal- und Querholme durch Eckverbinder verbunden sind.

Zur Herstellung von Gehäusen oder Schränken können derartige Rahmenkonstruktionen mit Verkleidungsteilen versehen werden. Für Gestelle werden beispielsweise wenigstens Seitenteile und Zwischenböden und für Geräteschränke zusätzlich ein Boden- und Deckenteil, eine Rückwand oder eine rückseitige Tür sowie eine frontseitige Tür befestigt. Baugruppenträger weisen in der Regel eine frontseitige Öffnung zur Aufnahme von Leiterplatten und deren Frontplatten auf.

Diese Konstruktionen müssen einer Reihe von Anforderungen genügen. Insbesondere muß eine dem jeweiligen Einsatzgebiet entsprechende mechanische Festigkeit gewährleistet sein. Außerdem sollte bei Geräteschränken bei Bedarf mit möglichst einfachen, wirkungsvollen Mitteln eine IP-Dichtigkeit und EMV-Abschirmung erreichbar sein.

Aus der FR-A 2 702 314 ist ein Metallschrank für elektrische Geräte mit einem Gestell und Verkleidungsteilen bekannt. Das Gestell weist front- und rückseitige Vertikalprofile sowie Tiefenholme in den Eckbereichen auf. Die Vertikalprofile und Tiefenholme sind ein- bzw. zweiseitig offene Profile und mit Befestigungsflanschen und rasterartig ausgebildeten Öffnungen zur Führung von Bolzen versehen, welche in Muttern gesichert werden. Zur Befestigung der Verkleidungsteile sind in den Tiefenholmen jeweils zwei Längsschlitze vorgesehen, in welche komplementäre Laschen der Verkleidungsteile eingeführt und verklemmt werden.

In der EP 0 399 596 A1 ist ein Gehäuse für elektrische Baugruppen und Geräte mit ablängbaren, asymmetrischen Flachprofilen beschrieben, welche die Seitenwände und die boden- und deckenseitige Abdeckung bilden. Die Verkleidungsteile weisen nach Fixierung von zusätzlichen Verbindungsteilen stirnseitige Aufnahmen auf, in welche Eckverbinder mit komplementär ausgebildeten Verbindungsbereichen eingesteckt werden. Zum Aufnahmeraum abgewinkelte Endbereiche der Verkleidungsteile bilden Befestigungsflansche und sind mit Bohrungen versehen, an denen Tiefenholme mit endseitig umgebogenen Bereichen über eine Bolzen-Mutter-Verbindung befestigt werden.

Die bekannten Rahmen, Gestelle, Gehäuse und Schränke werden diesen Erfordernissen nur bedingt und mit Hilfe aufwendiger Konstruktionen mit einer Vielzahl an Einzelbauteilen und unterschiedlichen Materialien und Verbindungstechniken gerecht.

So bedarf es beispielsweise bei Baugruppenträgern zum sicheren Befestigen von Leiterplatten einer normgerechten Herstellung von Gewinden in den frontseitigen Horizontalholmen, welche aufgrund der Anzahl mit einem erheblichen Aufwand verbunden ist und die Fertigungskosten negativ beeinflußt. Zur Dichtigkeit und insbesondere zur HF-Abschirmung sind zusätzliche technologische Maßnahmen und Verfahren, beispielsweise Oberflächenbehandlungen, erforderlich.

Der Erfindung liegt die **Aufgabe** zugrunde, ein außerordentlich einfaches, kostengünstiges Konstruktionssystem zu schaffen, welches vielseitig verwendbar und erweiterbar ist und sowohl für die Herstellung von Rahmen und Gestellen als auch für Gehäuse, Baugruppenträger und besonders vorteilhaft für Geräteschränke geeignet ist.

Erfindungsgemäß wird die Aufgabe durch die Merkmale des Anspruchs 1 gelöst. Zweckmäßige und vorteilhafte Ausgestaltungen und Weiterbildungen sind in den Unteransprüchen und in der Figurenbeschreibung enthalten.

Das erfindungsgemäße Konstruktionssystem geht von einer Verbindungs- oder Befestigungskonstruktion für horizontal und vertikal anzuordnende Bauteile aus und ermöglicht eine kostengünstige Herstellung eines Rahmens, eines Gestells, eines Gehäuses oder eines Schrankes, insbesondere eines Geräteschrankes.

Erfindungsgemäß weist das Konstruktionssystem Bauteile mit definierten Verbindungsbereichen auf. Insbesondere horizontal oder vertikal angeordnete Bauteile sind gemäß der Erfindung mit Einklinkungen oder Einzügen versehen, in denen ein Verbindungselement, welches zur Befestigung eines zweiten vertikal oder horizontal angeordneten Bauteils dient, selbsthemmend oder selbstschneidend fixierbar ist.

Die Einklinkungen als Einzüge, welche Verbindungsbereiche als angeformte Schraubkanäle für eine gewindeformende Schraube als Verbindungselement, darstellen, sind in einer fertigungstechnisch besonders vorteilhaften Weise und mit einem geringen Aufwand in einer Mehrfachabbiegung oder Abwinklung eines Flachmaterials eingebracht.

Es besteht somit beim erfindungsgemäßen Konstruktionssystem die Möglichkeit, von einem Flachmaterial definierten Zuschnitts auszugehen, was mit erheblichen Vorteilen bei der Herstellung, Montage, beim Einsatz und insbesondere auch bei der Entsorgung verbunden ist.

Erfindungsgemäß werden die Einklinkungen diametral zur Längsachse eines mehrfach abgebogenen, aus einem Zuschnitt gebildeten, Bauteils eingeformt. In einem durch Abwinklungen eines Zuschnitts gebildeten Aufnahmekanal ist eine kraftschlüssige Fixierung einer stirnseitig eingeführten, gewindeformenden Schraube durch vorzugsweise zwei voneinander beabstandete Einklinkungen möglich und damit eine sichere, rüttelfeste und erdbebensichere Befestigung wenigstens eines weiteren Bauteils gewährleistet.

Zum Aufbau eines Rahmens können beispielsweise vertikal, quer und horizontal angeordnete Holme, welche durch Abwinklungen eines Bleches gebildet sind und mit Verbindungsbereichen aus Einklinkungen versehen sind, verbunden werden.

Besondere Vorteile ergeben sich, wenn die Einklinkungen der Verbindungsbereiche an Horizontalholmen vorgesehen sind, die in Decken- und Bodenteile und/oder in Zwischenböden integriert sind. Derartige Bauteile mit mehrfach abgebogenen oder abgewinkelten Horizontalholmen können zum Aufbau eines Gestells oder eines Baugruppenträgers beispielsweise an Vertikalholmen befestigt werden.

Ebenso können Vertikalholme oder Bauteile mit integrierten Vertikalholmen mit derartigen Einklinkungen zur Bildung von stirnseitig zugänglichen, angeformten Schraubkanälen als Verbindungsbereiche versehen sein. Zur besonders stabilen Verbindung zwischen einem horizontal angeordneten Bauteil, z.B. einem Boden- oder Deckenteil, und Vertikalholmen mit Einklinkungen ist es zweckmäßig, jeweils in zwei Kantenbereichen, insbesondere in innenseitigen Kantenbereichen eines Vertikalholmes jeweils mindestens zwei übereinander angeordnete Einklinkungen einzuformen. Zur Befestigung eines Decken- oder Bodenteils oder eines Zwischenbodens können dann pro Vertikalholm und Verbindung zwei gewindeformende Schrauben, z.B. Blechschrauben, eingeführt und in einer besonderes effizienten gewindeformenden Weise verankert werden.

Zweckmäßigerweise werden Flachmaterialzuschnitte an definierten Bereichen einem Biegeprozeß unterworfen und mit im Querschnitt rechteckigen oder quadratischen front- und rückseitigen, integrierten Horizontalholmen oder Vertikalholmen versehen.

Die Einklinkungen werden wenigstens in stirnseitigen Endbereichen der in die horizontalen oder vertikalen Bauteile integrierten Holme und sinnvollerweise in wenigstens einem zu einem Innenraum gerichteten Kantenbereich ausgebildet.

Um eine kraftschlüssige Halterung eines Verbindungselementes, z.B. einer gewindeformenden Schraube, zu gewährleisten, können insbesondere quadratische oder rechteckige Einzüge in den Kantenbereichen der Horizontal- oder Vertikalholme eingeklinkt sein. Diese sichern nicht nur eine rüttel- und erdbebensichere Verankerung der Schrauben und somit eine langzeitstabile Befestigung der zu verbindenden Bauteile, z.B. eines Vertikalholms und eines Deckenteils oder Bodenteils, sondern gewährleisten auch eine gute Erdung der Konstruktionsanordnung.

Ein weiterer Vorteil ist eine mögliche Selbstjustierung des Verbindungselementes, welche auf die Einklinkungsausbildung der Verbindungselemente zurückzuführen ist.

Da es sich um ein lösbare Verbindung handelt und gängige Werkzeuge zur Handhabung der gewindeformenden Schraube verwendet werden können, ist eine effiziente Montage der erfindungsgemäßen Konstruktionsanordnung möglich.

Die Verwendung eines einheitlichen Flachmaterials für horizontal und vertikal angeordnete und zu verbindende Konstruktionsteile wirkt sich besonders vorteilhaft bei der Herstellung von Gehäusen, Baugruppenträgern und Geräteschränken aus. Indem zusätzlich zu den Decken- und Bodenteilen und/oder Zwischenböden auch Seitenteile als vertikale Bauteile und insbesondere mit integrierten Vertikalholmen aus einem Zuschnitt und zweckmäßigerweise aus dem gleichen Material gefertigt werden können und darüber hinaus mit einem weiteren, zweiten Verbindungsbereich für eine Steckverbindung versehen sind, ergeben sich zusätzliche Vorteile bei der Befestigung und Verbindung der Bauteile und insbesondere bezüglich einer wirkungsvollen EMV-Abschirmung.

Die Steckverbindungen umfassen Aufnahmen und komplementär ausgebildete Eingriffselemente, wobei die Aufnahmen bevorzugt an horizontalen Bauteilen, beispielsweise an einem Boden- und Deckenteil eines Geräteschrankes oder eines Baugruppenträgers, und die Eingriffselemente an oberen und unteren Kantenbereichen von vertikal angeordneten Seitenteilen ausgebildet sein können. Es besteht auch die Möglichkeit, als Ausformungen ausgebildete Aufnahmen an den Seitenteilen und Eingriffselemente am Boden- und Deckenteil vorzusehen. Beispielsweise ist es zur Befestigung einer Rückwand vorteilhaft, Eingriffselemente an der Rückwand vorzusehen, wobei diese zweckmäßigerweise an 90° abgewinkelten Kantenbereichen ausgebildet sind und in Aufnahmen der angrenzenden Verkleidungsteile, insbesondere der beidseitigen Seitenteile eingreifen können.

Die Steckverbindungen gewährleisten ein Vorfixieren der Bauteile, günstigenfalls mit Selbstjustierung, und eine rasterartige Befestigung, die eine besonders wirkungsvolle EMV-Abschirmung ermöglicht. Zu diesem Zweck sind an den Elementen der formschlüssig wirkenden Steckverbindungen Kontakte, beispielsweise noppenartige Ausprägungen, vorgesehen, welche beim Einschieben der Eingriffselemente in die Aufnahmen einen Materialabrieb bewirken. Für eine besonders effiziente EMV-Abschirmung ist es zweckmäßig, die Kontakte wechselseitig, d.h. an der Innenseite und an der Außenseite der Eingriffselemente, auszubilden.

Vorteilhaft für eine kostengünstige Fertigung der Konstruktionssysteme ist die Möglichkeit einer Vorfertigung der Elemente der Steckverbindungen in einem Flachmaterialzuschnitt. Die Ausbildung von Kontaktelementen, welche auch als Rastelemente der Steckverbindungen ausgebildet sein können, eine Ausformung von abgewinkelten und insbesondere zueinander gerichteten Seitenkanten an den horizontalen Decken- und Bodenteilen und der fingerartigen Eingriffselemente an den Seitenteilen kann in einem Stanz- und Prägevorgang vorgenommen werden.

Zur Erhöhung der Stabilität der Bauteile können zusätzliche Verstrebungen oder Versteifungssicken, beispielsweise im Eckbereich der abgewinkelten Seitenkanten am Decken- und Bodenteil, ausgebildet sein. Zur möglichst formschlüssigen Ausbildung der Steckverbindungen sind im Bereich der vorgefertigten Verstrebungen Ausnehmungen, z.B. Ausstanzungen im angrenzenden Kantenbereich der Seitenteile vorgesehen.

Eine verbesserte mechanische Festigkeit der Seitenteile kann ebenfalls durch Prägungen und Sicken mit einer definierten Formgebung und Anordnung erreicht werden.

Vorteilhaft ist bei Abbiegungen und Abwinklungen eine Sicherung durch Clinchen oder Toxen. Bei Baugruppenträgern empfiehlt sich im Eingriffsbereich von Steck- und Ziehhilfen für die Leiterplatten eine besonders stabile Ausbildung, beispielsweise eine Verdopplung, des frontseitigen Kantenbereichs eines horizontalen Bauteils. Die durch mehrfache Abwinklung oder Abbiegungen eines Flachmaterialzuschnittes gebildeten Horizontalholme sind zweckmäßigerweise zu einem Aufnahmeraum hin und zurückgesetzt von der frontseitigen Öffnung vorgesehen.

In einer weiteren Ausgestaltung der Erfindung weisen wenigstens die Horizontalholme dritte Verbindungsbereiche auf, die als Gewindebohrungen mit maximal einen Gewindegang umfassende Ein- oder Ausformungen ausgebildet sind und insbesondere rasterartig und in einer einer Norm entsprechenden Anzahl in dem Flachmaterialzuschnitt ausgebildet sind. In jeder Gewindebohrung ist eine gewindeformende Schraube, beispielsweise zur frontplattenseitigen Sicherung von Leiterplatten, fixierbar. Vorteilhaft ist eine Vorfertigung der Gewindebohrung im Zuschnitt, wodurch eine erhebliche Kostenreduzierung bei der Herstellung von Bauteilen, insbesondere von Vertikal- und Horizontalholmen, mit einer Vielzahl derartiger Gewindebohrungen erreicht wird.

In einer vorteilhaften Weiterbildung der Erfindung weist das Konstruktionssystem eine Rückwand auf, welche EMV-geschirmt mit den Seitenteilen sowie dem Deckenteil und dem Bodenteil verbunden werden kann. Analog zu den Seitenteilen ist die Rückwand aus einem einstückigen Flachmaterial durch Abkantungen bzw. Abwinklungen und Ausstanzungen und gegebenenfalls Prägungen gebildet und weist Kantenbereiche auf, welche fingerartige Eingriffselemente darstellen, die in entsprechende Aufnahmen der angrenzenden Verkleidungsteile, insbesondere der Seitenteile formschlüssig aufgenommen werden. Eine EMV-Abschirmung wird insbesondere über Kontaktelemente an den Eingriffselementen erreicht, welche mit den Aufnahmen zusammenwirken.

Zusätzlich zu dieser insbesondere selbstzentrierenden Verbindung von Rückwand und angrenzenden Verkleidungsteilen ist in einer Weiterbildung vorgesehen, die Rückwand über Verriegelungseinrichtungen zu sichern. Diese Verriegelungseinrichtungen sind zweckmäßigerweise nahe den Seitenteilen und beispielsweise in einem oberen und einem unteren Bereich der Rückwand vorgesehen und weisen wenigstens eine Riegelzunge oder einen Riegelhaken, insbesondere an der Rückwand, und eine mit der Riegelzunge oder dem Riegelhaken zusammenwirkenden Riegelaufnahme, insbesondere an dem angrenzenden Seitenteil, auf.

Eine besonders zweckmäßige Verriegelungseinrichtung weist eine an der Innenseite der Rückwand geführte Riegelplatte mit zwei zur angrenzenden Seitenwand gerichteten Riegelzungen auf. Die Riegelplatte ist über einen Bolzen mit einem Griffelement in einer Ausnehmung der Rückwand geführt und kann aus einer Entriegelungsstellung über einen Verstellweg, z.B. in einer Riegelführung, in eine Verriegelungsstellung bewegt werden. Als Riegelführung eignet sich in einer konstruktiv einfachen Ausgestaltung eine Ausnehmung in der Rückwand. Bei Verwendung von Rändelschrauben als Riegelhalterungen, ist es vorteilhaft, daß gleichzeitig Halteelemente vorhanden, die bei der Montage und Demontage der Rückwand genutzt werden können. Eine sichere Verriegelung wird mit hakenartigen Riegelzungen oder mit einer rechtwinkligen Ausnehmung, in welcher die Rändelschraube oder ein Bolzen mit Halteelement horizontal und danach vertikal nach unten geführt werden kann, erreicht.

Die Riegelaufnahmen sind komplementär zu den Riegelzungen bzw. Riegelhaken oder ähnlichen Verriegelungselementen der Riegelplatte ausgebildet und bevorzugt in Vertikalholmen der Seitenteile, z.B. als schlitzartige Ausnehmungen, ausgebildet. In einer besonders zweckmäßigen Ausbildung können die Riegelaufnahmen auch direkt in den Seitenteilflächen ausgebildet sein. Grundsätzlich können die Verriegelungseinrichtungen zur Halterung der Rückwand auch mit dem Dekkenteil und/oder dem Bodenteil zusammenwirken.

Das erfindungsgemäße Konstruktionssystem ist aufgrund des möglichen Einsatzes eines einheitlichen Flachmaterials, beispielsweise von CrNi-Stahl, und der Vorfertigung von Ausstanzungen, Einprägungen und dergleichen besonders günstig in der Herstellung, Montage und der Beherrschung der Variantenvielfalt. Die Verwendung eines einheitlichen Materials mit besonders guten Korrosions- und Abschirmeigenschaften sowie die geringen Übergangsflächen zwischen den Bauteilen infolge der geringen Bauteil-Anzahl ermöglichen eine gute EMV-Eigenschaft der Konstruktionsanordnungen.

Wesentliche Vorteile ergeben sich aufgrund des einheitlichen Materials und der Bearbeitung durch Biegen, Toxen und Clinchen für die Entsorgung eines Rahmens, Gestells, Gehäuses, Baugruppenträgers oder Schrankes. Ein Demontieren zwecks Sortierung und Zuordnung verschiedener Materialien kann somit entfallen. Die Charakterisierung und einfache Zuordnung des Materials erleichtert eine Aufbereitung und Wiederverwendung und führt zu äußerst geringen Kosten.

In einer Ausgestaltung der Erfindung ist eine "black box" als ein gehäuseartiger Auf- oder Anbau an oder auf den Gehäusen und Baugruppenträgern zur Aufnahme zusätzlicher Komponenten, beispielsweise nichtgenormter Baugruppen, Schalter, Stecker und dergleichen, vorgesehen.

Diese Erfindung wird nachstehend beispielhaft anhand einer schematischen Zeichnung weiter erläutert; in dieser zeigen:
- Fig. 1: einen erfindungsgemäß ausgebildeten Baugruppenträger in einer Explosionsdarstellung;
- Fig. 2: eine vergrößerte Darstellung der ersten Verbindungsbereiche mit Einklinkungen gemäß Ausschnitt II der Fig. 1;
- Fig. 3: eine schematische Darstellung eines horizontal angeordneten Bauteils mit integrierten Horizontalholmen;
- Fig. 4: eine schematische und vergrößerte Darstellung der als zweite Verbindungsbereiche ausgebildeten Steckverbindungen gemäß Ausschnitt IV der Fig. 1;
- Fig. 5: eine schematische, vergrößerte Darstellung eines eingeformten Gewindeganges gemäß Ausschnitt V der Fig. 1;
- Fig. 6: eine schematische Darstellung einer Seitenkantenausbildung eine horizontalen Bauteils;
- Fig. 7: einen erfindungsgemäß ausgebildeten Geräteschrank in einer perspektivischen Teilansicht;
- Fig. 8: eine schematische Teildarstellung eines vertikal geschnittenen Deckenteils eines Geräteschrankes gemäß Fig. 7, jedoch mit einer gewindeformenden Schraube zur Schraubbefestigung;
- Fig. 9: einen Horizontalschnitt durch ein Seitenteil eines Geräteschrankes gemäß Fig. 7 mit Vertikalholmen und Einklinkungen;
- Fig. 10: eine perspektivische Teildarstellung eines Vertikalholmes eines Seitenteils eines Geräteschrankes gemäß Fig. 7 und 9;
- Fig. 11: eine perspektivische Teilansicht von Verkleidungsteilen eines Geräteschrankes mit einer horizontal ausgerichteten Steckverbindung und
- Fig. 12: eine stark schematisierte Darstellung einer Rückwand in einem oberen Bereich mit einer Verriegelungseinrichtung.

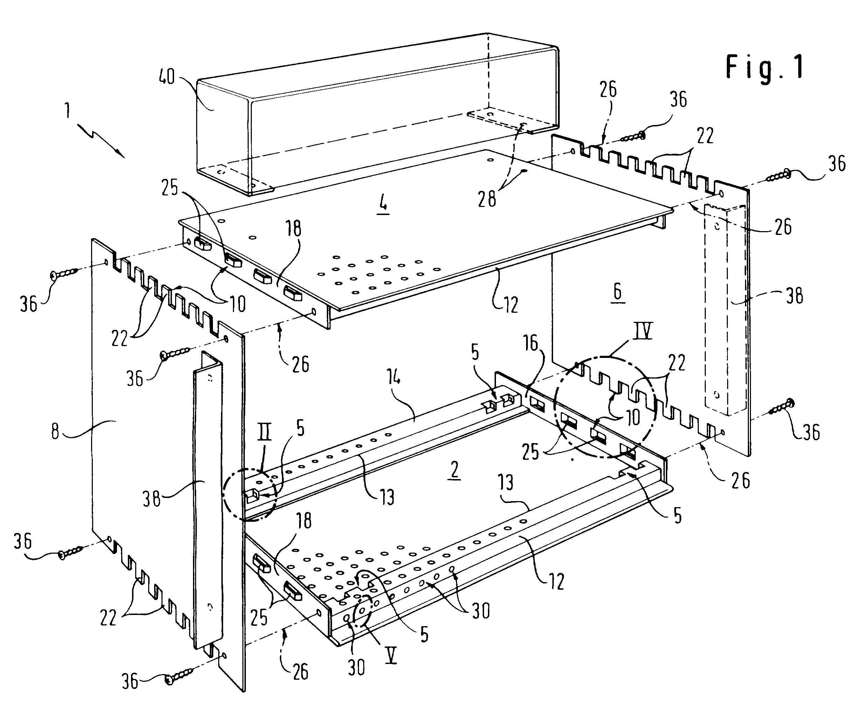

In Fig. 1 ist als eine erste Ausbildungsvariante einer erfindungsgemäßen Konstruktionsanordnung ein Baugruppenträger 1 in einer Explosionsdarstellung gezeigt.

Der Baugruppenträger 1 weist als horizontal angeordnete Bauteile ein Bodenteil 2 und ein Deckenteil 4 auf, welche frontseitige Horizontalholme 12 und rückseitige Horizontalholme 14 in einer integrierten Ausbildung aufweisen. Das Bodenteil 2 und das Deckenteil 4 sowie die darin integrierten Horizontalholme 12, 14 sind aus einem Zuschnitt eines Flachmaterials, bevorzugt aus einem Chrom-Nickel-Stahlblech gefertigt. Die Horizontalholme sind durch Mehrfachabbiegungen, in diesem Beispiel durch eine 180-Grad- und 90-Gradabwinklungen, gebildet und an einem innenseitigen Kantenbereich durch Präge- oder Clinchverbindungen 11 gesichert.

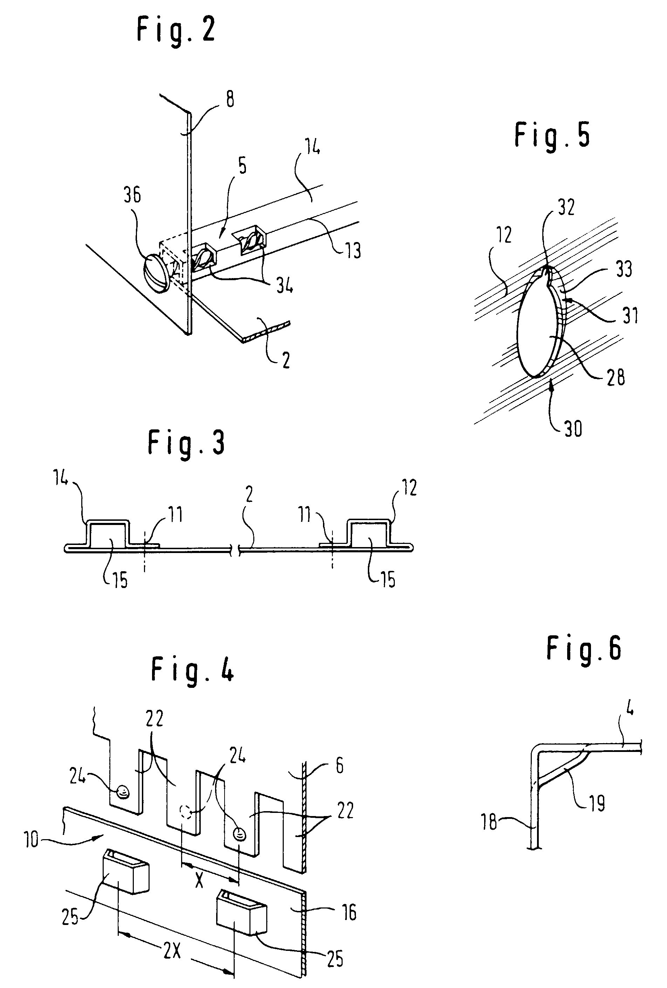

In Fig. 3 ist in einer stark schematisierten Darstellung ein Bodenteil 2 mit integrierten Horizontalholmen 12, 14 gezeigt, wobei die Horizontalholme 12, 14 durch Mehrfachabbiegungen bzw. Abwinklungen gebildet und durch Clinchverbindungen 11 an einem innenseitigen Abbiegeschenkel befestigt sind.

Die Horizontalholme 12, 14 weisen in diesem Ausführungsbeispiel einen rechteckigen Querschnitt auf und definieren einen Aufnahmekanal 15 für stirnseitige Verbindungselemente 36. Mit Hilfe der Verbindungselemente 36, die mit ersten Verbindungsbereichen 5 der integrierten Horizontalholme 12, 14 zusammenwirken, können Seitenteile 6, 8 als Verkleidungsteile des Baugruppenträgers 1 mit dem Bodenteil 2 und dem Deckenteil 4 verbunden werden.

Die Ausbildung der ersten Verbindungsbereiche 5 ist gemäß Ausschnitt II in Fig. 2 dargestellt. Die ersten Verbindungsbereiche 5 sind als rechtwinklig oder diametral zur

Längsachse der integrierten Horizontalholmen 12, 14 eingebrachte Einklinkungen oder Einzüge 34 ausgebildet. Die abgewinkelten Horizontalholme 12, 14 und die insbesondere rechtwinkligen Einklinkungen 34 nahe den Stirnbereichen der Horizontalholme 12, 14 gewährleisten eine sichere, langzeitstabile Fixierung sowie eine rüttelfeste und erdbebensichere Verankerung von gewindeformenden Schrauben 36. Derartige gewindeformende Schrauben 36, welche bevorzugt als Verbindungselemente der ersten Verbindungsbereiche 5 verwendet werden, sind an den Ausklinkungen 34 gehalten, wodurch eine sichere Verbindung eines Seitenteiles 6, 8 und eines Decken- und Bodenteils 2, 4 oder eines ähnlichen horizontal angeordneten Bauteils gewährleistet ist.

Eine derartige Verbindungskonstruktion ist ebenso für Horizontalholme und Vertikal- bzw. Querholme möglich. Besonders vorteilhaft ist diese Verbindungstechnik bei Bauteilen mit integrierten Holmen und darin eingeformten Einklinkungen. Wie aus Fig. 1 hervorgeht, kann auf diese Weise mit besonders wenigen Bauteilen ein Baugruppenträger, eine Gehäuse oder ein Geräteschrank gefertigt werden. Besonders vorteilhaft ist die Verwendung eines Materials, welches jeweils als einstückiges Flachmaterial Biege- und Stanz- und/oder Prägeprozessen unterworfen wird. Es ergeben sich besonders kurze Bearbeitungszeiten, bedeutend geringere Logistikkosten aufgrund einer geringen Teileanzahl und eines günstigeren Einkaufs sowie insbesondere kurze Montagezeigen.

Diese kurzen Montagezeiten sind nicht nur durch erste Verbindungsbereiche 5, sondern insbesondere durch zweite Verbindungsbereiche bei der Herstellung von Baugruppenträgern, Gehäusen und Geräteschränken gegeben. Derartige zweite Verbindungsbereiche 10 sind Steckverbindungen, welche als Aufnahmen 25 und als Eingriffselemente 22, insbesondere rasterförmig ausgebildet sind und zusammenwirken.

Die Steckverbindungen ermöglichen eine Vorfixierung und bei entsprechender Ausbildung eine selbstjustierende Befestigung der Seitenteile 6, 8 an dem Bodenteil 2 und Deckenteil 4 sowie einer Rückwand 7 an den Seitenteilen 6, 8 und/oder an dem Bodenteil 2 und/oder an dem Deckenteil 4.

Eine bevorzugte Ausbildung ist in einer vorgrößerten Darstellung des Ausschnittes IV gemäß Fig. 1 in Fig. 4 gezeigt. Die Aufnahmen 25 sind an rechtwinklig ausgebildeten Seitenkanten 16, 18 des Bodenteils 2 und des Deckenteils 4 ausgebildet und nehmen fingerartig geformte Eingriffselemente 22, welche an einem oberen und unteren Kantenbereich der Seitenteile 6, 8, beispielsweise durch mäanderförmige Ausstanzungen gebildet sind, auf. Um eine EMV-Abschirmung zu gewährleisten, sind Kontaktelemente 24 insbesondere an den fingerartigen Eingriffselementen 22 ausgebildet, welche zu einem Materialabrieb beim Ineinanderschieben an den Aufnahmen 25 führen. Zweckmäßig ist die Ausbildung entsprechend langer fingerartiger Eingriffselemente 22 und die Anordnung von noppenartigen Kontaktelementen 24, derart, daß diese gleichzeitig als Rastelemente der ineinandergesteckten Verkleidungsteile 2, 4, 6, 8 dienen können.

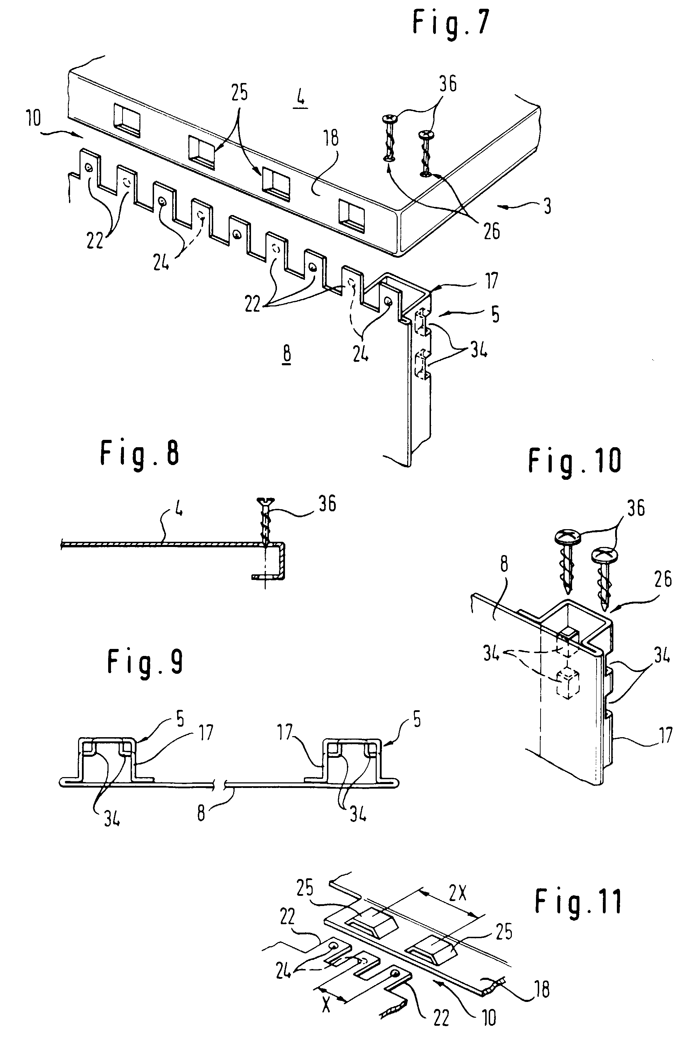

Zweckmäßigerweise sind die Schraubbefestigungen 26 der ersten Verbindungsbereiche 5 und auch die Steckverbindungen 10 der zweiten Verbindungsbereiche in Richtung Aufnahmeraum des Baugruppenträgers 1 ausgebildet, so daß der äußere Gesamteindruck nicht nachteilig beeinflußt ist. Es ist aus der Darstellung der zweiten Verbindungsbereiche 10 in Fig. 4 und in Fig. 11 erkennbar, daß sowohl die Eingriffselemente 22 als auch die Aufnahmen 25 rasterartig ausgebildet sein können. Ein Rastermaß von Eingriffselementen 22 zu Aufnahme 25 im Verhältnis 2:1 und eine wechselseitige Ausbildung von noppenartigen Kontaktelementen 24 als Ausformungen an den Innen- oder Außenflächen der Eingriffselemente 22 sichert eine besonders gute EMV-Abschirmung.

Nach dem Herstellen der Steckverbindungen werden die Schraubbefestigungen 26 realisiert. Zweckmäßigerweise können L-förmige und vertikal an den Außenflächen der Seitenteile 6, 8 angeordnete Befestigungsflansche 38 gleichzeitig durch die Schraubbefestigungen 26 befestigt werden. Das Deckenteil 4 und das Bodenteil 2 sind in diesem Beispiel als ein Lochblech ausgebildet.

Bei Verwendung der erfindungsgemäßen Konstruktionsanordnung als Baugruppenträger, als Gehäuse oder als Geräteschrank empfiehlt es sich, dritte Verbindungsbereiche 30 derart in den Horizontalholmen 12, 14 anzubringen, daß eine frontplattenseitige Befestigung von eingeschobenen Leiterplatten möglich ist (Fig. 5).

Im Gegensatz zum Stand der Technik werden die in einer großen Anzahl herzustellenden Verbindungsbereiche 30 als ausgeformte Gewindegänge 28 in den integrierten frontseitigen Horizontalholmen 12 ausgebildet, so daß die herkömmliche, aufwendige Herstellung von Gewindegängen entfallen kann. Dadurch ergibt sich eine wesentliche Reduzierung des Fertigungsaufwandes.

Ein derartiger aus- oder angeformter Gewindegang 28 ist als eine nahezu kreisförmige Öffnung ausgebildet und weist eine Verformung 33 von einem halben bis einen Gewindegang als Angriffsbereich für eine gewindeformende Schraube auf. Die Verformung 33 als ein partieller Gewindegang 28 umfaßt einen sichelartigen Bereich 31 und eine Ausnehmung 32, wobei wenigstens der sichelartige Bereich 31 in die Öffnung hineinragt und nach außen oder innen abgebogen ist.

Vorteile der angeformten Gewindegänge sind eine mögliche Vorfertigung und eine sichere Fixierung und Verankerung der Gewindeschrauben (siehe dazu Fig. 5). Derartige dritte Verbindungsbereiche 30 sind deshalb auch vorteihaft bei Gestellen, Gehäusen und Geräteschränken und können in Vertikalholmen und/oder Horizontalholmen vorgesehen sein.

In Fig. 6 ist als eine weitere vorteilhafte Ausbildung eine Querverstrebung 19 in schematischer Darstellung gezeigt. Derartige Querverstrebungen 19 bewirken eine zusätzliche Versteifung der Seitenkanten 16, 18, welche rechtwinklig und zueinander gerichtet am Bodenteil 2 bzw. am Deckenteil 4 ausgebildet sind. Die angrenzenden Kantenbereiche der Seitenteile 6, 8 sind mit komplementären Ausnehmungen zu versehen, um eine besonders dichte und wirkungsvolle EMV-Abschirmung zu gewährleisten. Diese Querverstrebungen erhöhen insbesondere bei Geräteschränken, Gestellen oder Gehäusen die Stabilität und Festigkeit.

Die Fig. 7 bis 11 zeigen in Teildarstellungen einen Geräteschrank als eine weitere Variante eines erfindungsgemäßen Konstruktionssystems.

In Fig. 7 ist in einer teilweisen, perspektivischen Darstellung ein Geräteschrank 3 im Bereich eines vertikalen Seitenteils 8 und eines Deckenteils 4 dargestellt.

In einer fertigungstechnisch und montagemäßig vorteilhaften Weise sind am Seitenteil 8 erste Verbindungsbereiche 5 in Form von Einklinkungen 34 in Vertikalholmen 17 und zweite Verbindungsbereiche 10 mit Eingriffselementen 22 am Seitenteil 8 und Aufnahmen 25 an Seitenkanten 18 des Deckenteils 4 ausgebildet. Die Eingriffselemente 22 sind komplementär zu den Aufnahmen 25 ausgebildet und gewährleisten eine formschlüssige Verbindung. Noppenartige Kontaktelemente 24, die wechselseitig an der Innen- und Außenfläche der Eingriffselemente 22 ausgebildet sind, sichern eine gute EMV-Abschirmung.

Die über die Steckverbindungen 10 vorfixierbaren Verkleidungsteile 4, 8 werden mit dem in Eckbereichen angeordneten Schraubbefestigungen 26 kraftschlüssig verbunden. Dazu sind in den Vertikalholmen 17 (siehe auch Fig. 9 und 10), welche durch Abwinklungen oder Abkantungen eines einzigen Blechzuschnittes gebildet sind, Einklinkungen 34 oder Einzüge als erste Verbindungsbereiche 5 in den zum Innenraum gerichteten Kantenbereichen eingeformt. In diese eingeformten Schraubkanäle werden in diesem Beispiel zwei selbsthemmende, gewindeformende Schrauben 36 zur Befestigung des Dekkenteils 4 in einem Eckbereich eingeführt und befestigt.

Fig. 8 zeigt eine mögliche Ausbildung eines Deckenteils 4. Dieses Deckenteil 4 ist ebenfalls aus einem Zuschnitt durch Abbiegungen gebildet. Während das Deckenteil 4 der Fig. 7 in den Eckbereichen über zwei gewindeformende Schrauben 36 befestigt wird, ist bei dem Deckenteil 4 der Fig. 8 nur eine gewindeformende Schraube 36 pro Schraubverbindung 26 vorgesehen.

Fig. 11 zeigt eine horizontal ausgerichtete Steckverbindung 10, welche z.B. zur Herstellung einer "black box" 40 gemäß Fig. 1 oder ähnlicher Gehäuse ausgebildet sein kann. Aufnahmen 25 und Eingriffselemente 22 mit Kontaktnoppen 24 sind an horizontal abgewinkelten Kantenbereichen der entsprechenden Bauteile ausgebildet und greifen formschlüssig ineinander. Im Bereich der Steckverbindungen 10 kann eine zusätzliche Dichtung vorgesehen werden, um eine möglichst gute IP-Dichtheit zu erreichen. Eine wirkungsvolle EMV-Abschirmung wird über die Kontaktnoppen 24 erreicht, welche in den Aufnahmen 25 und in den dazwischenliegenden Kantenbereichen 18 einen wirkungsvollen Kontakt der Verkleidungsteile sichern.

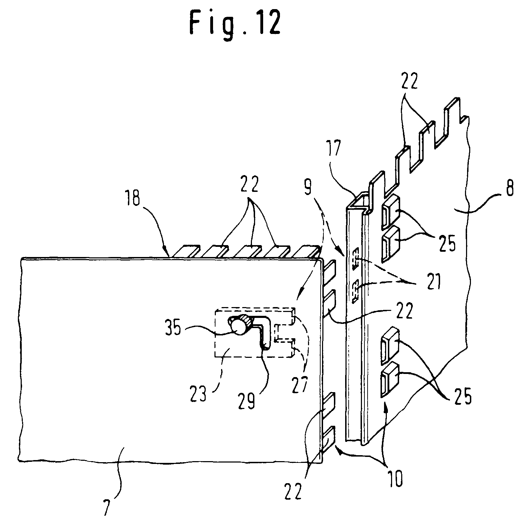

In Fig. 12 sind in einer ausschnittsweisen Darstellung eine Rückwand 7 und ein Seitenteil 8 eines Geräteschrankes mit einer Verriegelungseinrichtung 9 gezeigt. An der Rückwand 7 sind Eingriffselemente 22 in einer etwa 90°-Abwinklung ausgebildet, welche mit Aufnahmen 25, welche lediglich in dem dargestellten Seitenteil gezeigt sind, als zweite Verbindungsbereiche selbsjustierend zusammenwirken. An den Eingriffselementen 22 und/oder im Inneren der Aufnahmen 25 können Kontaktnoppen (nicht dargestellt) ausgebildet sein, um eine wirkungsvolle EMV-Abschirmung auch in diesem Gehäuse- bzw. Schrankbereich zu erreichen.

Die Verriegelungseinrichtung 9 weist Riegelzungen 27 an einer verstellbaren, innenseitig angeordneten Riegelplatte 23 auf. Die Riegelplatte 23 ist über eine nach außen geführte Riegelhalterung 35, welche einen Bolzen und ein Griffelement aufweist und beispielsweise als eine Rändelschraube ausgebildet sein kann, wenigstens horizontal verstellbar. Durch eine horizontale Verstellung gelangen die in diesem Beispiel rechteckig ausgebildeten Riegelzungen 27 mit Riegelaufnahmen 21 am angrenzenden Seitenteil 8 in Eingriff.

Wenn die Riegelzungen 27 hakenförmig bzw. abgewinkelt ausgebildet sind, ist eine besonders sichere Verriegelung gegeben. Diese wird noch dadurch unterstützt, wenn eine etwa rechtwinklige Riegelführung bzw. Ausnehmung 29 vorgesehen ist. Die Möglichkeit der Halterung bei der Montage und Demontage einer Rückwand 7 mit den von außen betätigbaren Rändelschrauben oder Riegelhalterungen 35 ist besonders vorteilhaft.

## Patentansprüche

1. Konstruktionssystem für Rahmen, Gestelle und Gehäuse, Baugruppenträger und Schränke, beispielsweise für Geräteschränke zur Aufnahme von elektrischen und elektronischen Baugruppen, Geräten und Leiterplatten, mit vertikal und horizontal angeordneten Bauteilen (2, 4, 6, 8), welche über Verbindungsbereiche (5) und Verbindungselemente (36) miteinander verbunden sind, wobei erste Verbindungsbereiche (5) in Mehrfachabbiegungen oder Abwinklungen eines Flachmaterials als stirnseitige Aufnahmekanäle (15) ausgebildet sind, dadurch **gekennzeichnet**,
daß die Aufnahmekanäle (15) Einklinkungen (34) aufweisen, welche als Einzüge jeweils diametral zur Längsachse des Aufnahmekanals (15) ausgebildet sind, und
daß an den Einklinkungen (34) gewindeformende Schrauben (36) als Verbindungselemente fixierbar sind, die in die Aufnahmekanäle (15) einführbar sind.

2. Konstruktionssystem nach Anspruch 1,
dadurch **gekennzeichnet**,
daß die ersten Verbindungsbereiche (5) in Horizontalholme (12, 14) oder in Querholme als horizontal angeordnete Bauteile und/oder in Vertikalholme (17) als vertikal angeordnete Bauteile integriert sind,
daß quer angeordnete, vertikal und/oder horizontal angeordnete Bauteile an den Stirnseiten der Horizontalholme (12, 14), der Querholme und/oder der Vertikalholme (17) durch die gewindeformenden Schrauben (36) als selbsthemmende Verbindungselemente fixierbar sind, und
daß die Horizontalholme (12, 14), Querholme und/oder Vertikalholme (17) einen quadratischen oder rechteckigen Querschnitt aufweisen und für die Aufnahmekanäle (15) jeweils wenigstens ein Kantenbereich (13), der insbesondere innenseitig angeordnet ist, mit den Einklinkungen (34) oder Einzügen für eine Schraubbefestigung (26) versehen ist.

3. Konstruktionssystem nach Anspruch 2,
dadurch **gekennzeichnet**,
daß die Horizontalholme (12, 14), Querholme und/oder Vertikalholme (17) mit stirnseitig zugänglichen ersten Verbindungsbereichen (5) für eine Schraubbefestigung (26) in Verkleidungsteile (2, 4, 6, 7, 8) eines Gestells, Gehäuses, eines Baugruppenträgers (1) oder eines Geräteschrankes (3) integriert sind,
daß insbesondere die Horizontalholme (12, 14) in ein Deckenteil (4) und in ein Bodenteil (2) als Verkleidungsteile integriert sind, welche über Schraubverbindungen (26) an Querholmen, Vertikalholmen oder an Seitenteilen (6, 8) als Verkleidungsteile fixierbar sind, und/oder
daß die Vertikalholme (17) in Seitenteile (6, 8) als Verkleidungsteile integriert und ein Deckenteil (4) und ein Bodenteil (2) als Verkleidungsteile über Schraubverbindungen (26) fixierbar sind, wobei insbesondere bei Geräteschränken wenigstens zwei Schrauben (36) an jeder Schraubverbindung (26) eines Vertikalholmes (17) vorgesehen sind.

4. Konstruktionssystem nach Anspruch 3,
dadurch **gekennzeichnet**,
daß das Deckenteil (4) und das Bodenteil (2) mit Seitenkanten (16, 18) versehen sind, daß die Horizontalholme (12, 14) oder die Vertikalholme (17) die ersten Verbindungsbereiche (5) für eine selbsthemmende Schraubbefestigung (26) aufweisen und daß im Bereich der Verkleidungsteile (2, 4, 6, 8), insbesondere im Bereich der Seitenteile (6, 8) und an den Seitenkanten (16, 18), zweite Verbindungsbereiche (10) vorgesehen sind.

5. Konstruktionssystem nach Anspruch 4,
dadurch **gekennzeichnet,**
daß die zweiten Verbindungsbereiche (10) als Steckverbindungen (10) zur Befestigung von Seitenwänden oder Seitenteilen (6, 8) an dem Decken- oder Bodenteil (2, 4) und/oder zur Befestigung einer Rückwand (7) an den Seitenteilen (6, 8) und/oder dem Decken- und/oder Bodenteil (2, 4) vorgesehen und insbesondere als eine selbstzentrierende Verbindung ausgebildet sind,
wobei das Deckenteil (4), das Bodenteil (2), die Rückwand (7) und/oder die Seitenteile (6, 8) jeweils aus einem einstückigen Flachmaterial durch Abkantungen, Abwinklungen, Mehrfachabbiegungen, Ausstanzungen und/oder Prägungen gebildet sind.

6. Konstruktionssystem nach Anspruch 5,
dadurch **gekennzeichnet,**
daß von dem Decken- und Bodenteil (4, 2) und den Seitenteilen (6, 8), welche über Steckverbindungen (10) sowie über Schraubverbindungen (26) im Bereich der Horizontalholme (12, 14) und/oder Vertikalholme (17) verbunden sind, ein selbsttragendes Gehäuse, ein Baugruppenträger (1) oder ein Geräteschrank (3) gebildet ist.

7. Konstruktionssystem nach Anspruch 4 oder 5,
dadurch **gekennzeichnet,**
daß an der Rückwand (7) zusätzlich zu den Steckverbindungen (10) Verriegelungseinrichtungen (9) zur Sicherung der Rückwand (7) an den Seitenteilen (6, 8) und/oder an dem Deckenteil (4) und/oder an dem Bodenteil (2) vorgesehen sind.

8. Konstruktionssystem nach einem der Ansprüche 5 bis 7,
dadurch **gekennzeichnet,**
daß die Steckverbindungen (10), welche insbesondere EMV-abschirmend und/oder rasterartig ausgebildet sind, Aufnahmen (25) und komplemetär ausgebildete Eingriffselemente (22) aufweisen,
daß die Aufnahmen (25) insbesondere in Seitenkanten (16, 18) des Boden- und Deckenteils (2, 4) und die Eingriffselemente (22) in den Seitenteilen (6, 8) zur Verbindung der Seitenteile (6, 8) mit dem Boden- und/oder Deckenteil (2, 4) ausgebildet sind und/oder daß die Rückwand (7) mit den Eingriffselementen (22) versehen ist, welche in kantennahe Aufnahmen (25) der Seitenteile (6, 8) und/oder des Deckenteils (4) und/oder des Bodenteils (2) eingreifen.

9. Konstruktionssystem nach Anspruch 8,
dadurch **gekennzeichnet**,
daß die Aufnahmen (25) als Ausbuchtungen in einem Stanz- und Biegeprozess und die Eingriffselemente (22), welche beim Verbinden fingerartig in die Aufnahmen (25) eingreifen, durch Ausstanzungen in einem oberen und unteren Kantenbereich der Seitenteile (6, 8) und/oder durch Ausstanzungen und Abwinklungen von Kantenbereichen der Rückwand (7) gebildet sind,
wobei die Eingriffselemente (22) mit Kontaktelementen (24) versehen sind, welche mit den Aufnahmen (25) zusammenwirken und gegebenenfalls Rast- oder Sicherungselemente der Steckverbindungen (10) bilden.

10. Konstruktionssystem nach einem der vorhergehenden Ansprüche,
dadurch **gekennzeichnet**,
daß dritte Verbindungsbereiche (30) als ausgeformte Gewindebohrungen (28) ausgebildet sind, die mit gewindeformenden Schrauben zusammenwirken, wobei die dritten Verbindungsbereiche (30) jeweils eine etwa kreisförmige Öffnung mit einer Verformung (33) als Angriffsbereich für eine gewindeformende Schraube aufweisen.

11. Konstruktionssystem nach Anspruch 10,
dadurch **gekennzeichnet**,
daß die dritten Verbindungsbereiche (30), die insbesondere zur Befestigung von Frontplatten dienen, in einem Flachmaterial vorgefertigt und nach einer Mehrfachabbiegung in integrierten Horizontalholmen (12, 14), Querholmen und/oder Vertikalholmen (17) angeordnet sind.

12. Konstruktionssystem nach Anspruch 7,
dadurch **gekennzeichnet**,
daß jede Verriegelungseinrichtung (9) wenigstens eine Riegelzunge (27) aufweist, welche nach einer Verstellung in wenigstens eine Riegelaufnahme (21), welche im Bereich der Seitenteile (6, 8) und/oder des Bodenteils (2) und/oder des Deckenteils (4) ausgebildet ist, eingreift.

13. Konstruktionssystem nach Anspruch 12,
dadurch **gekennzeichnet**,
daß die Verriegelungseinrichtung (9) eine Riegelplatte (23) aufweist, an welcher die wenigstens eine Riegelzunge (27) ausgebildet ist, daß die Riegelplatte (23) über eine Riegelhalterung (35) geführt und in Richtung des jeweils angrenzenden Verkleidungsteils (2, 4, 6, 8) insbesondere in Richtung der Seitenteile (6, 8) verstellbar ist, wobei
die Riegelhalterung (35), z.B. eine Rändelschraube, in einer Ausnehmung (29) der Rückwand (7) geführt, von außen betätigbar ist und gleichzeitig als Griffelement zur Halterung der Rückwand dient.

14. Konstruktionssystem nach Anspruch 13,
dadurch **gekennzeichnet**,
daß die Ausnehmung (29) rechtwinklig in der Rückwand (7) verläuft, daß die wenigstens eine Riegelzunge (27) der Riegelplatte (23) rechtwinklig oder hakenartig ausgebildet ist und nach einer horizontalen und vertikalen Verstellung die Riegelaufnahmen (21) der angrenzenden Verkleidungsteile (2, 4, 6, 8) hintergreift und daß die Rückwand (7) im Bereich der angrenzenden Seitenteile (6, 8) wenigstens obere Verriegelungseinrichtungen (9) aufweist.

15. Konstruktionssystem nach einem der vorhergehenden Ansprüche 3 bis 14,
dadurch **gekennzeichnet**,
daß mit den Schraubverbindungen (26) ein etwa L-förmiger Befestigungsflansch (38) an den äußeren Seitenteilen (6, 8) fixierbar ist und/oder daß auf dem Deckenteil (4) ein gehäuseartiger Aufbau (40), insbesondere für nichtgenormte Baugruppen, Schalter, Stecker und dergleichen, fixierbar ist, wobei der gehäuseartige Aufbau (40) aus einem Flachmaterialzuschnitt gebildet und durch selbstschneidende gewindeformende Schrauben an Gewindegängen (28) fixierbar ist.

## Claims

1. A constructional system for frames, racks and casings, module carriers and cabinets, for example, for equipment cabinets for accommodating electrical and electronic assemblies, units and printed circuit boards, having vertically and horizontally arranged components (2,4,6,8,) which are connected to each other by way of joint zones (5) and fastening elements (36), wherein first joint zones (5) in multi-bendings or foldings of a flat material are designed as end face location channels (15),
**characterized** in that,
the location channels (15) are provided with engagements (34), which as indentations are formed in each case diametrally to the longitudinal axis of the location channels (15), and
that thread-forming screws (36) which can be introduced into the location channels (15) can be fixed to the engagements (34) as fastening elements.

2. A constructional system according to claim 1,
**characterized** in that,
the first joint zones (5) are integrated into horizontal struts (12, 14) or into cross struts as horizontally arranged components and/or into vertically struts (17) as vertically arranged components,
that crosswise arranged vertically and/or horizontally arranged components can be fixed to the end faces of horizontal struts (12, 14), of cross struts and/or vertical struts (17) by the thread-forming screws (36) as self-locking fastening elements, and
that the horizontal struts (12, 14), cross and/or vertical struts (17) feature a quadratic or rectangular cross-section, and for the location channels (15) in each case at least one edge zone (13), which in particular is arranged on the inside, is provided with the engagements (34) or indentations for a screw fixing (26).

3. A constructional system according to claim 2,
**characterized** in that,
the horizontal struts (12, 14), cross struts and/or vertical struts (17) having first joint zones (5) accessible from the end face are integrated for a screw fixing (26) in panel parts (2, 4, 6, 7, 8) of a rack, casing, of a module carrier (1) or of an equipment cabinet (3),
that in particular the horizontal struts (12, 14) are integrated into a top part (4) and into a base part (2) as panel parts, which can be fixed by means of screw connections (26) to cross struts, vertical struts or to side parts (6, 8), as panel parts and/or
that the vertical struts (17) are integrated into side parts (6, 8) as panel parts and a top part (4) and a base part (2) can be fixed as panel parts by means of screw connections (26), wherein, in particular, at least two screws (36) are provided at each screw connection (26) of a vertical strut (17) for equipment cabinets.

4. A constructional system according to claim 3,
**characterized** in that,
the top part (4) and the base part (2) are provided with side edges (16, 18), that the horizontal struts (12, 14) or the vertical struts (17) feature the first joint zones (5) for a self-locking screw fixing (26) and that in the region of the panel parts (2, 4, 6, 8), especially in the region of the side parts (6, 8) and on the side edges (16, 18) are provided second joint zones (10).

5. A constructional system according to claim 4,
**characterized** in that,
the second joint zones (10) are provided as lug joints (10) for fixing of side walls or side parts (6, 8) to the top part (4) or the base part (2) and/or for fixing of a rear wall (7) to the side parts (6, 8) and/or to the top part (4) and/or base part (2) and are designed in particular as a self-centering joint, wherein the top part (4), the base part (2), the rear wall (7) and/or the side parts (6, 8) are formed in each case from a single piece flat material by bending edges, folding edges, multi-bends, stamping out material and/or embossments.

6. A constructional system according to claim 5,
**characterized** in that,
by the top and base part (4, 2) and by the side parts (6, 8) which are connected by means of lug joints (10) and by means of screw connections (26) in the region of the horizontal struts (12, 14) and/or vertical struts (17), is formed a self-supporting casing, a module carrier (1) or an equipment cabinet (3).

7. A constructional system according to claim 4 or 5,
**characterized** in that,
on the rear wall (7), additional to the lug joints (10), are provided locking devices (9) to secure the rear wall (7) to the side parts (6, 8) and/or to the top part (4) and/or to the base part (2).

8. A constructional system according to any of the claims 5 to 7,
**characterized** in that,
the lug joints (10), which in particular are designed to have EMC screening properties and/or in a comb-like interlocking manner, feature locations (25) and complementarily designed engagement elements (22),
that the locations (25) especially in side edges (16, 18) of the base and top part (2, 4) and the engagement elements (22) in the side parts (6, 8) are designed for connecting the side parts (6, 8) with the base and/or top part (2, 4) and/or that the rear wall (7) is provided with the engagement elements (22), which engage in locations (25) close to the edge of the side parts (6, 8) and/or of the top part (4) and/or of the base part (2).

9. A constructional system according to claim 8,
**characterized** in that,
the locations (25) are formed as bulges in a stamping and bending process and the engagement elements (22) engaging finger-like into the locations (25) for connecting, are formed by stamped out material in an upper and lower edging zone of the side parts (6, 8) and/or by stamped out material and folding of edging zones of the rear wall (7), wherein the engagement elements (22) are provided with contact elements (24), which function in conjunction with the locations (25) and, if need be, form detent elements or locking elements of the lug joints (10).

10. A constructional system according to any of the previous claims,
**characterized** in that,
third joint zones (30) are designed as formed threaded holes (28), which function together in conjunction with thread-forming screws, wherein the third joint zones (30) feature in each case an approximately circular shaped orifice having a deformation (33) as a start engagement zone for a thread-forming screw.

11. A constructional system according to claim 10,
**characterized** in that,
the third joint zones (30), which in particular serve for fixing of fascia plates, are prefabricated in a flat material and are arranged in integrated horizontal struts (12, 14), cross struts and/or vertical struts (17) after a multi-bending operation.

12. A constructional system according to claim 7,
**characterized** in that,
each locking device (9) features at least one locking latch (27), which after movement, engages in at least one locking catch (21), which is formed in a region of the side parts (6, 8) and / or of the base part (2)and / or of the top part (4).

13. A constructional system according to claim 12,
**characterized** in that
the locking device (9) features a locking plate (23) on which the at least one locking latch (27) is formed, that the locking plate (23) is guided by means of a bolt retainer (35) and is movable in the direction of the respective adjacent panel part (2, 4, 6, 8) especially in the direction of the side parts (6, 8), wherein the bolt retainer (35), e.g. a knurled screw, is guided in a cutout (29) of the rear wall (7), operable from outside and simultaneously serves as a gripping element for holding the rear wall.

14. A constructional system according to claim 13,
**characterized** in that,
the cutout (29) runs at right angles in the rear wall (7), that the at least one locking latch (27) of the locking plate (23) is formed at right angles or hook-like and engages behind the locking catches (21) of the adjacent panel parts (2, 4, 6, 8) after a horizontal and vertical movement and that the rear wall (7) features at least upper locking devices (9) in the region of the adjacent side parts (6, 8).

15. A constructional system according to any of the previous claims 3 to 14,
**characterized** in that,
an approximately "L" shaped fixing flange (38) can be fixed to the outer side parts (6, 8) with the screw connections (26) and/or that a case-like construction (40), especially for non-standardised assemblies, switches, plugs and the like can be attached on the top part (4), whereby the case-like construction (40) is formed from a made-to-measure flat material section and can be fixed by self-cutting thread-forming screws to threads (28).

## Revendications

1. Système constructif pour cadres, châssis et boîtiers, supports de modules et armoires, par exemple pour des armoires à instruments destinées à recevoir des composants, appareils et circuits imprimés électriques et électroniques, avec des éléments (2, 4, 6, 8) disposés verticalement et horizontalement, qui sont reliés entre eux par des zones de liaison (5) et des éléments de liaison (36), des premières zones de liaison (5) étant conformées en canaux récepteurs frontaux (15) dans des courbures multiples ou pliures d'un matériau plat, ***caractérisé en ce que*** les canaux récepteurs (15) présentent des enclenchements (34) qui sont à chaque fois conformés en renfoncements de manière diamétrale par rapport à l'axe longitudinal du canal récepteur (15), et ***en ce qu'***au niveau des enclenchements (34) peuvent être fixées des vis autotaraudeuses (36) servant d'éléments de liaison, qui peuvent être introduites dans les canaux récepteurs (15).

2. Système constructif selon la Revendication 1, ***caractérisé en ce que*** les premières zones de liaison (5) sont intégrées dans des barres horizontales (12, 14) ou dans des barres transversales en tant qu'éléments disposés horizontalement, et/ou dans des barres verticales (17) en tant qu'éléments disposés verticalement, ***en ce que*** des éléments disposés transversalement de manière verticale et/ou horizontale peuvent être fixés par les vis autotaraudeuses (36) en tant qu'éléments de liaison autobloquants au niveau des faces frontales des barres horizontales (12, 14), des barres transversales et/ou des barres verticales (17), et ***en ce que*** les barres horizontales (12, 14), les barres transversales et/ou les barres verticales (17) présentent une section carrée ou rectangulaire et, prévu pour les canaux récepteurs (15), il est prévu à chaque fois au moins une zone de bord (13), qui est placée de préférence à l'intérieur, avec les enclenchements (34) ou renfoncements pour une fixation par vis (26).

3. Système constructif selon la Revendication 2, ***caractérisé en ce que*** les barres horizontales (12, 14), les barres transversales et/ou les barres verticales (17) sont intégrées, avec de premières zones de liaison (5) accessibles du côté frontal pour une fixation par vis (26), dans des parties d'habillage (2, 4, 6, 7, 8) d'un châssis, d'un boîtier, d'un support (1) de modules ou d'une armoire à instruments (3), ***en ce qu'***en particulier les barres horizontales (12, 14) sont intégrées dans une partie de couverture (4) et dans une partie de fond (2) en tant que parties d'habillage, qui peuvent être fixées par des assemblages vissés (26) sur des barres transversales, des barres verticales ou sur des parties latérales (6,8) servant de parties d'habillage, et/ou ***en ce que*** les barres verticales ( 17) sont intégrées dans des parties latérales (6, 8) servant de parties d'habillage et une partie de couverture (4) et une partie de fond (2) peuvent être fixées en tant que parties d'habillage par des assemblages vissés (26). au moins deux vis (36) étant prévues, en particulier dans le cas d'armoires à instruments, au niveau de chaque assemblage vissé (26) d'une barre verticale (17).

4. Système constructif selon la Revendication 3, ***caractérisé en ce que*** la partie de couverture (4) et la partie de fond (2) sont munies de bords latéraux (16, 18), ***en ce que*** les barres horizontales (12, 14) ou les barres verticales (17) présentent les premières zones de liaison (5) pour une fixation vissée autobloquante (26) et ***en ce qu'***au niveau des parties d'habillage (2, 4, 6, 8), en particulier au niveau des parties latérales (6, 8) et sur les bords latéraux (16, 18), deux zones de liaison (10) sont prévues.

5. Système constructif selon la Revendication 4, ***caractérisé en ce que*** les deux zones de liaison (10) sont prévues sous la forme d'assemblages encliquetés (10) pour la fixation de parois latérales ou de parties latérales (6, 8) sur la partie de couverture ou de fond (2, 4) et/ou pour la fixation d'une paroi arrière (7) sur les parties latérales (6, 8) et/ou la partie de couverture et/ou de fond (2, 4), et sont conformées en particulier en assemblage à centrage automatique, la partie de couverture (4), la partie de fond (2), la paroi arrière (7) et/ou les parties latérales (6. 8) étant formées chacune d'un matériau plat d'un seul tenant, par des rabats, des pliures, des courbures multiples. des matriçages et/ou des estampages.

6. Système constructif selon la Revendication 5, ***caractérisé en ce que,*** depuis les parties de couverture et de fond (4, 2) et les parties latérales (6.8), lesquelles sont reliées par des assemblages encliquetés (10) et des assemblages vissés (26) au niveau des barres horizontales (12, 14) et/ou des barres verticales (17), est formé un boîtier autoporteur, un support de modules ( 1 ) ou une armoire à instruments (3).

7. Système constructif selon la Revendication 4 ou 5, ***caractérisé en ce que,*** sur la paroi arrière (7), en plus des assemblages encliquetés (10) sont prévus des dispositifs de verrouillage (9) pour fixer la paroi arrière (7) aux parties latérales (6, 8) et/ou à la partie de couverture (4) et/ou à la partie de fond (2).

8. Système constructif selon l'une quelconque des Revendications 5 à 7, ***caractérisé en ce que*** les assemblages encliquetés (10), qui sont conformés en particulier en écran contre le rayonnement électromagnétique et/ou en réseau, présentent des logements (25) et des éléments de prise (22) de conformation complémentaire, ***en ce que*** les logements (25) sont formés en particulier dans les bords latéraux (16, 18) des parties de couverture et de fond (2, 4) et les éléments de prise (22) dans les parties latérales (6, 8) pour relier les parties latérales (6, 8) à la partie de couverture et/ou de fond (4, 2), et/ou ***en ce que*** la paroi arrière (7) est munie des éléments de prise (22), lesquels s'engagent dans des logements (25) proches du bord des parties latérales (6, 8) et/ou de la partie de couverture (4) et/ou de la partie de fond (2).

9. Système constructif selon la Revendication 8, ***caractérisé en ce que*** les logements (25) sont formés par des indentations dans un procédé d'estampage et de pliage et les éléments de prise (22), lesquels s'engagent à la manière de doigts dans les logements (25) lors de l'assemblage, par des matriçages dans des zones de bord supérieure et inférieure des parties latérales (6, 8) et/ou par des matriçages et pliures de zones de bord de la paroi arrière (7), les éléments de prise (22) étant munis d'éléments de contact (24), qui coopèrent avec les logements (25) et forment le cas échéant des éléments d'encliquetage ou de fixation des assemblages encliquetés (10).

10. Système constructif selon l'une quelconque des Revendications précédentes, ***caractérisé en ce que*** des troisièmes zones de liaison (30) sont conformées en perçages filetés démoulés (28), qui coopèrent avec des vis autotaraudeuses, les troisièmes zones de liaison (30) présentant chacune une ouverture approximativement circulaire avec une déformation (33) servant de zone de prise pour une vis autotaraudeuse.

11. Système constructif selon la Revendication 10, ***caractérisé en ce que*** les troisièmes zones de liaison (30), qui servent en particulier à la fixation de plaques frontales, sont préfabriquées dans un matériau plat et sont placées après des courbures multiples dans des barres horizontales (12, 14), des barres transversales et/ou des barres verticales (17) intégrées.

12. Système constructif selon la Revendication 7, ***caractérisé en ce que*** chaque dispositif de verrouillage (9) présente au moins une languette de verrouillage (27) qui, après déplacement, s'engage dans au moins un logement de verrouillage (21) qui est formé au niveau des parties latérales (6, 8) et/ou de la partie de fond (2) et/ou de la partie de couverture (4).

13. Système constructif selon la Revendication 12, ***caractérisé en ce que*** le dispositif de verrouillage (9) présente une plaque de verrouillage (23), sur laquelle est formée la languette de verrouillage (27) au nombre d'au moins une, ***en ce que*** la plaque de verrouillage (23) passe sur un support de verrouillage (35) et est mobile en direction de la partie d'habillage (2, 4, 6, 8) voisine respective, en particulier en direction des parties latérales (6, 8), le support de verrouillage (35), par exemple une vis moletée, passant dans un évidement (29) de la paroi arrière (7), étant manoeuvrable depuis l'extérieur et servant simultanément d'élément de prise afin de tenir la paroi arrière.

14. Système constructif selon la Revendication 13, ***caractérisé en ce que*** l'évidement (29) s'étend à angle droit dans la paroi arrière (7), ***en ce que*** la languette de verrouillage (27) au nombre d'au moins une de la plaque de verrouillage (23) est conformée à angle droit ou en crochet et saisit par l'arrière les logements de verrouillage (21) des parties d'habillage (2, 4, 6, 8) après un déplacement horizontale et vertical, et ***en ce que*** la paroi arrière (7) présente au niveau des parties latérales voisines (6, 8) au moins des dispositifs de verrouillage supérieurs (9).

15. Système constructif selon l'une quelconque des Revendications 3 à 14, ***caractérisé en ce qu'***au moyen des assemblages vissés (26), une bride de fixation (38) approximativement en L peut être fixée aux parties latérales extérieures (6, 8) et/ou ***en ce que,*** sur la partie de couverture (4) peut être fixée une structure (40) de type boîtier, en particulier pour des composants non normalisés, des commutateurs, des prises et analogues, la structure (40) de type boîtier étant formée d'une section de matière plate et pouvant être fixée par des vis autoperceuses autotaraudeuses dans des filetages (28).
